# EUROPEAN PATENT APPLICATION

(11) **EP 1 422 762 A1**
(43) Date of publication of application: **26.05.2004**
(21) Application number: 02758804.5
(22) Date of filing: 08.08.2002
(51) Int. Cl.: H01L 31/042, C23C 16/30

(54) **PHOTOELECTRIC CONVERSION DEVICE−USE SUBSTRATE**

(30) Priority: 10.08.2001 JP 2001244694
(71) Applicant: Nippon Sheet Glass Company, Limited, Osaka-shi, Osaka 541-8559 (JP)
(72) Inventor: FUJISAWA, Akira c/o NIPPON SHEET GLASS CO., LTD., Osaka-shi, Osaka 541-8559 (JP); SUEYOSHI, Yukio c/o NIPPON SHEET GLASS CO., LTD., Osaka-shi, Osaka 541-8559 (JP)
(74) Representative: Matthews, Derek Peter
(86) International application number: PCT/JP2002/008096
(87) International publication number: WO 2003/017378

(57) **Abstract**

The present invention provides a substrate for a photoelectric conversion device contributing to enhance further the effect of trapping light into a photoelectric conversion layer. The substrate includes a first undercoating film containing at least one selected from tin oxide, titanium oxide, indium oxide and zinc oxide as a main component, a second undercoating film and a conductive film formed in this order on a glass sheet containing an alkali component. Concavities are formed in the surface of the second undercoating film, and the area ratio of the concavities is in the range of 20% to 50%.

## Description

### TECHNICAL FIELD

The present invention relates to a substrate for a photoelectric conversion device and a method of manufacturing the same.

### BACKGROUND ART

An undercoating film is provided between a glass sheet and a conductive film of a substrate for a photoelectric conversion device, in some cases, for preventing an alkali component in the glass sheet from diffusing into the conductive film. Diffusion of an alkali component such as sodium into the conductive film may degrade of the characteristics of the conductive film. For prevention of diffusion of an alkali component, a silicon oxide film normally is used.

In a thin film solar cell (thin film photoelectric conversion device), surface irregularities of a crystalline conductive film are used for trapping light into a photoelectric conversion layer. For this reason, many studies have been made on the surface profile of the conductive layer. To attain a large light trapping effect, the haze ratio, which reflects the surface irregularities, should preferably be high.

JP 2001-53307 A discloses a substrate for a photoelectric conversion device, which uses an undercoating film to obtain large surface irregularities of a conductive film. In this substrate, a first undercoating film formed on a glass sheet has holes, and a second undercoating film has irregularities caused by the holes. Due to the irregularities of the second undercoating film, crystal grains to constitute the conductive film grow to a larger size locally. With this, the haze ratio of the substrate increases.

The substrate disclosed in JP 2001-53307 A has another advantage of being suitable for industrial mass production. However, limitations exist in the number and size of holes of the undercoating film that can be formed by the method disclosed in this publication. To attain a further enhanced light trapping effect, a higher haze ratio is requested for the substrate for a photoelectric conversion device.

### DISCLOSURE OF THE INVENTION

An object of the present invention is to further improve a substrate for a photoelectric conversion device of whose haze ratio is enhanced using an undercoating film and a method of manufacturing the same.

In order to achieve the aforementioned object, the substrate for a photoelectric conversion device of the present invention includes a first undercoating film containing at least one selected from tin oxide, titanium oxide, indium oxide and zinc oxide as a main component, a second undercoating film and a conductive film formed in this order on a glass sheet containing an alkali component, wherein concavities are formed in the surface of the second undercoating film, and the area ratio of the concavities is in a range of 20% to 50%, preferably in a range of 20% to 40%.

According to the substrate for a photoelectric conversion device described above, concavities exist in the surface of the second undercoating film at a ratio higher than conventionally obtained, and hence the conductive film has increased surface irregularities. This increases the haze ratio of the entire film including the undercoating films and the conductive film, and thus provides a greater light trapping effect. If the area ratio of the concavities is excessively high, crystal grains constituting the conductive film may grow abnormally from projections remaining between the concavities as the starting points. In view of this, according to the present invention, the area ratio is set in the range described above.

Considering the distribution at the area ratio described above, the mean diameter of the concavities may be of the order of 100 nm to about 1000 nm. Preferably, it should be 200 nm to 600 nm. If the mean diameter of the concavities is excessively small, a number of scattered small holes will be present, and hence the surface irregularities of the conductive film will fail to grow to a sufficient size. On the other hand, if the mean diameter is excessively large, large concavities will exist sparsely, and hence the effect obtained from the surface irregularities in the second undercoating film will not be sufficiently provided.

The concavities in the surface of the second undercoating film, having an area ratio and a mean diameter falling within the respective preferred ranges described above, can be formed by reflecting the surface profile of the first undercoating film, such as concavities, more specifically, holes and/or recesses, preferably holes, of the first undercoating film. As used herein, the "hole" refers to a concave extending through the film (through hole), and the "recess" refers to a concave that does not extend through the film (non-through hole). The "concave" simply refers to the state that the surface of a portion retreats from its surroundings. The concavities of the second undercoating film are preferably "recesses" for prevention of diffusion of an alkali component. In other words, the second undercoating film preferably exists over the entire interface between the first undercoating film and the conductive film.

A preferred embodiment of the present invention is a substrate for a photoelectric conversion device in which concavities are formed on the surface of the second undercoating film by reflecting the surface profile of the first undercoating film. The area ratio of the concavities is in the range of 20% to 50%, preferably in the range of 20% to 40%. The mean diameter of the concavities is in the range of 200 nm to 600 nm, preferably in the range of 200 nm to 500 nm.

The present invention also provides a method suitable for manufacture of a substrate for a photoelectric conversion device. This method includes forming a first undercoating film containing at least one selected from tin oxide, titanium oxide, indium oxide and zinc oxide as a main component, a second undercoating film and a conductive film in this order on a glass sheet containing an alkali component or a glass ribbon in a glass sheet manufacturing process, wherein the first undercoating film is formed on the glass sheet or the glass ribbon having a temperature of 600°C or more, preferably 650°C or more, by chemical vapor deposition using a film forming gas so that concavities are formed on the surface of the first undercoating film. The film forming gas may include a compound gas containing at least one of metal selected from tin, titanium, indium and zinc and a halogen-containing gas that does not contain the metal. Subsequently, the second undercoating film may be formed so that concavities reflecting the concavities of the first undercoating film can be formed in the surface of the second undercoating film.

The halogen-containing gas promotes generation of concavities on the first undercoating film, and thus the area ratio of concavities of the second undercoating film increases. The method disclosed in JP 2001-53307 A used a compound containing a metal that is a main component of the film and a halogen (for example, organic tin chloride), and a halogen (for example, chlorine) was provided only from decomposition of this compound. In this conventional method, the halogen was not sufficiently supplied to the glass surface, and thus formation of holes was limited. According to the method of the present invention, the reaction between an alkali component (for example, sodium) of the glass surface and the halogen (for example, chlorine) is promoted by use of the halogen-containing gas that does not contain the above metal and has higher reactivity. This increases the number of concavities (holes and/or recesses) formed with disappearance of salt (for example, sodium chloride) produced by the reaction. If a halogen is contained in the compound of the metal (that is, if a compound gas containing metal atoms and halogen atoms is used) to enable supply of a halogen from the both gases, generation of concavities can be promoted further.

The substrate for a photoelectric conversion device of the present invention also can be obtained by a method different from the manufacturing method described above. This method includes forming a first undercoating film containing at least one selected from tin oxide, titanium oxide, indium oxide and zinc oxide as a main component, a second undercoating film and a conductive film in this order on a glass sheet or a glass ribbon in a glass sheet manufacturing process, wherein a corrosive gas is supplied to at least one surface selected from the surface of the glass sheet or the glass ribbon, the surface of the first undercoating film and the surface of the second undercoating film, to erode the surface chemically. The kind of the corrosive gas is not limited as long as the gas can act chemically on the surface to which the gas is supplied to form concavities, and may be selected according to the material constituting the surface.

By adopting the method described above, to allow the corrosive gas to act on the second undercoating film, concavities can be formed in the surface of the second undercoating film without relying on the surface profile of the first undercoating film. Thus, the concavities of the second undercoating film may or may not originate from the surface profile of the first undercoating film. The method using concavities formed on the first undercoating film and the method using a corrosive gas may be employed in combination.

Another preferred embodiment of the present invention is a substrate for a photoelectric conversion device in which the second undercoating film having concavities is formed on the first undercoating film having a substantially flat surface. The area ratio of the concavities is in the range of 20% to 50%, preferably in the range of 20% to 40%. The mean diameter of the concavities is in the range of 200 nm to 600 nm, preferably in the range of 200 nm to 500 nm.

### BRIEF DESCRIPTION OF THE DRAWINGS

FIG. 1 is a cross-sectional view of an embodiment of the substrate for a photoelectric conversion device according to the present invention.
FIG. 2 is a cross-sectional view of an embodiment of the substrate for a photoelectric conversion device (excluding a conductive film) according to the present invention.
FIG. 3 is a view of a configuration of an apparatus for manufacturing the substrate for a photoelectric conversion device according to the present invention.
FIG. 4 is a view of the surface state, observed with a SEM, of a second undercoating film of an example of the substrate for a photoelectric conversion device according to the present invention.
FIG. 5 is a view of the surface state, observed with a SEM, of a second undercoating film of an example of the substrate for a photoelectric conversion device according to the present invention.

### EMBODIMENTS OF THE INVENTION

Hereinafter, preferred embodiments of the present invention will be described with reference to the relevant drawings.

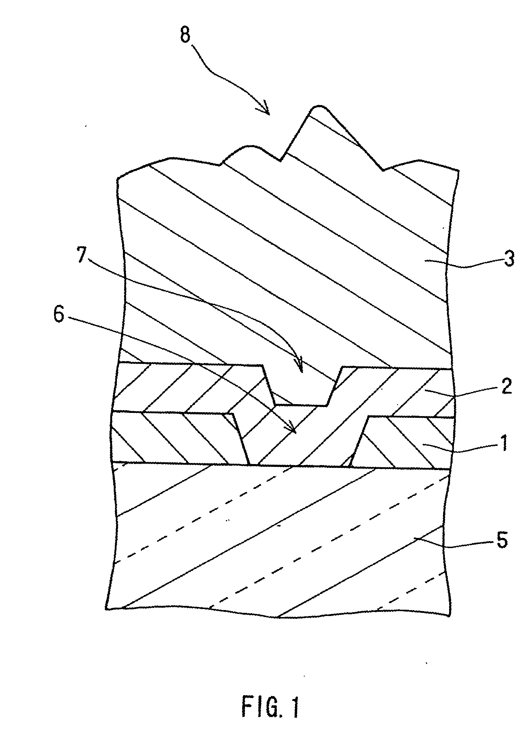

FIG. 1 is a cross-sectional view of an example of the substrate for a photoelectric conversion device of the present invention. The substrate includes a first undercoating film 1, a second undercoating film 2 and a conductive film 3 formed in this order on a smooth surface of a glass sheet 5. The first undercoating film 1 has a hole 6 formed to extend through the film. The second undercoating film 2 fills the hole 6, and as a result, a concave 7 is formed on the second undercoating film 2 at a position above the hole 6.

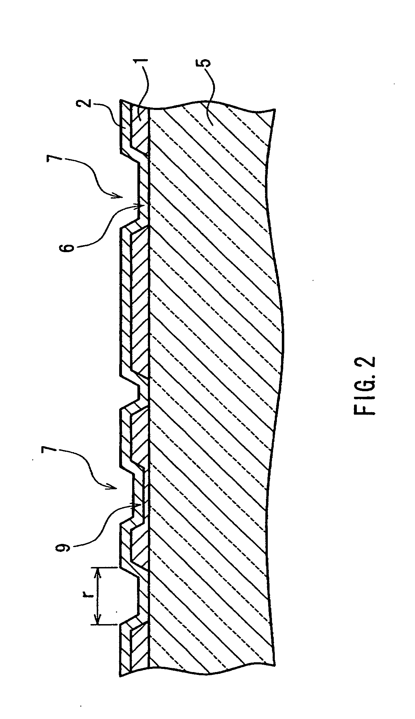

FIG. 2 is a cross-sectional view of an example of the substrate in the state where only the undercoating films 1 and 2 are formed. The concavities 7 are scattered on the surface of the second undercoating film 2, with a ratio of the area of the concavities to the area of the entire surface of the undercoating film falling within the predetermined range specified above. The concavities 7 also are formed above recesses 9 of the first undercoating film 1, not only above the holes 6. The mean diameter of the concavities 7 is obtained by determining the diameters of circular concavities having the same area as the respective concavities and calculating the average of the determined diameters. Assuming that the illustrated concavities are circular as is viewed from top, the diameter of the concavities corresponds to "r" in FIG. 2.

The surface irregularities of the conductive film 3 tend to be large at positions above the concavities 7. This is because the irregularities of the second undercoating film 2 serve as nuclei for growth of crystal grains. Actually, in many cases, largely grown crystals locally exist at positions above concavities. With thus-formed large crystal grains 8 being scattered, light incident on the substrate (normally incident from the bottom side of the glass sheet 5 as is viewed from FIG. 1) is scattered more intensely at the interface between the second undercoating film 2 and the conductive film 3 and also at the surface of the conductive film. As a result, the haze ratio of the entire film improves.

With the second undercoating film 2 covering the entire surface of the glass sheet 5, the conductive film 3 is prevented from coming in contact with the glass sheet 5 even though the through holes 6 are formed. In this way, the second undercoating film 2, preferably existing over the entire interface between the conductive film 3 and the glass sheet 5, suppresses diffusion of an alkali component from the glass sheet into the conductive film and thus suppresses degradation of the conductive film.

The first undercoating film 1 is preferably a crystalline coating including at least one selected from tin oxide, titanium oxide, indium oxide and zinc oxide as a main component. A main component of a material as used herein refers to a component constituting at least 50 wt.% of the material, as is generally defined. Therefore, the use of the "main component" does not exclude the addition of trace components. The first undercoating film may contain fluorine, chlorine and other trace components. An example of the undercoating film containing another component is a silicon-containing tin oxide film (SnSiO).

The second undercoating film 2 preferably includes at least one selected from silicon oxide and aluminum oxide as a main component. In particular, a silicon oxide film is preferred. In the second undercoating film, also, addition of other sub-components is not excluded. Preferred examples of the second undercoating film include a silicon oxycarbide film (SiOC) and a tin-containing silicon oxide film (SiSnO).

The conductive film 3 preferably includes tin oxide as a main component. For improvement of the conductivity, a tin oxide film with a trace component such as fluorine and antimony added thereto is particularly preferred. The amount of the added element is not particularly limited, but is suitably 0.05 wt.% to 1 wt.% if fluorine is added. Other crystalline oxides such as zinc oxide may be used as a main component of the conductive film.

Preferred thicknesses of the respective films are as follows. In the parentheses, further preferred thickness ranges are shown.
First undercoating film: 10 nm to 100 nm (20 nm to 80 nm)
Second undercoating film: 10 nm to 100 nm (20 nm to 60 nm)
Conductive film: 400 nm to 1500 nm (600 nm to 1000 nm)

The ratio of the thickness (T₂) of the second undercoating film to the thickness (T₁) of the first undercoating film (T₂/T₁) is preferably in the range of 0.2 to 2.0, particularly in the range of 0.3 to 1.2. If this ratio is excessively low, the second undercoating film is thin and thus may fail to provide sufficiently the effect of preventing the diffusion of an alkali component. On the other hand, if the ratio is excessively high, the portions above the holes may be flattened. Irregularities also are generated on the surface of the first undercoating film with growth of crystal grains. However, the irregularities of the first undercoating film having a thickness as small as that described above are so extremely minute that the surface can be considered substantially flat. In practice, these minute irregularities are flattened with the second undercoating film, and hence have no influence on the surface of the second undercoating film.

The substrate of the present invention is not limited to the configuration illustrated and described above. For example, when concavities are formed directly in the surface of the second undercoating film as described before, the first undercoating film may be flat. More specifically, a silicon oxide film may be formed as the second undercoating film, and a corrosive gas such as hydrogen fluoride (HF) gas, for example, may be sprayed on the surface of the silicon oxide film. In this way, concavities that do not originate from the surface profile of the first undercoating film can be formed on the second undercoating film. A corrosive gas may be sprayed on the glass as the base plate. HF gas is also suitable as the corrosive gas sprayed on the glass. By forming irregularities in the glass surface in advance, the surface irregularities of the second undercoating film can be made greater. This method is advantageous when a thin undercoating film is desired. In addition, a desired haze ratio can be obtained easily without thickening the conductive film.

The shape and distribution of the concavities are not limited to those described above. Although the undercoating films and the conductive film provide the respective effects sufficiently as the single-layer films, they may be composed of a plurality of layers. These films can be formed suitably by a method described hereinafter, but the formation method is not limited to this. A preformed glass sheet may be used as the base plate.

A preferred method for industrially mass-producing the substrate described above is an on-line CVD method, in which the respective films described above are sequentially deposited on the top surface of a glass ribbon by use of heat of the glass ribbon in a float glass manufacturing process. The top surface as used herein refers to the surface opposite to the surface (bottom surface) subjected to formation in contact with tin in a float bath in the floating process.

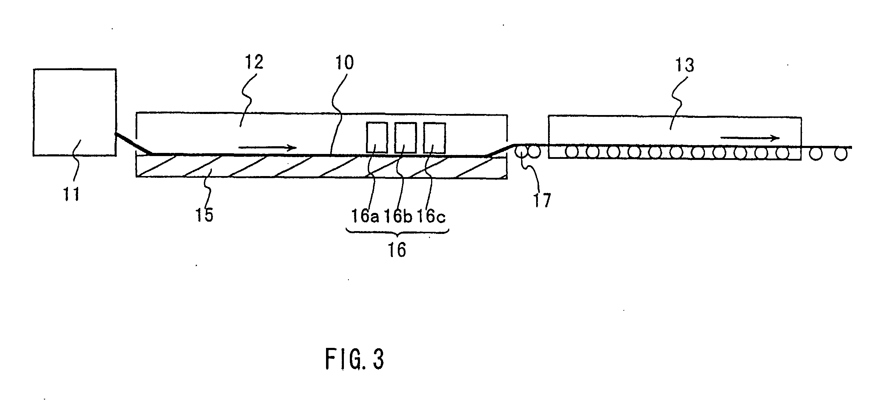

FIG. 3 shows an example of an apparatus for forming a thin film by CVD on a surface of a glass ribbon in the floating process. In this apparatus, molten glass material is poured from a furnace 11 into a tin float bath 12, and moves downstream on a bed of tin 15 inside the bath while being formed into a glass ribbon 10 of a belt shape. Inside the bath, a predetermined number of coaters 16 (three coaters 16a, 16b and 16c in the illustrated example) are positioned directly above the glass ribbon 10. The number and placement of the coaters can be selected appropriately depending on the type and thickness of the coating film to be formed. These coaters supply evaporated material (film forming gas) to the surface of the glass ribbon 10, to thereby form a film. The temperature of the glass ribbon 10 is controlled with a heater and a cooler (both not shown) placed inside the tin float bath 12 so that the glass ribbon 10 has a predetermined temperature immediately before arrival at the coaters 16. The glass ribbon 10 with the film formed thereon is lifted out from the tin float bath 12 with rolls 17, cooled in an annealing furnace 13, and then cut into a predetermined size.

To form concavities (holes and/or recesses) in the first undercoating film, a film forming gas containing a halogen compound may be supplied to the glass having a high temperature (for example, 600°C, preferably 650°C or more) to form a film. Halogen atoms (for example, chlorine atoms) react with an alkali component (for example, sodium) included in the glass to produce salt (for example, sodium chloride), and this salt disappears, forming concavities. The upper limit of the temperature of the glass is not particularly limited, but normally, a temperature of 750°C or less is suitable.

To increase the number of concavities and increase the size of these concavities, the production of salt may be promoted. For promotion of the production of salt, it is effective to increase the substrate temperature, increase the halogen concentration and use a highly reactive halogen-containing gas, among others. If the halogen is supplied only from a compound used for supply of metal atoms to the film, independent control of only the halogen supply amount is impossible. Therefore, to enhance the halogen concentration, a halogen gas or a halide gas (for example, chlorine gas, hydrogen chloride gas and chloroform) that does not contain the metal used as a main component of the coating film may be added to the film forming gas. These gases have higher reactivity for the glass surface than the halogen-containing compound containing the metal described above.

The added amount of the halogen-containing gas may be any value within the range that can exhibit the effect, but desirably may be 2 mol% to 20 mol% of the film forming gas.

Examples of the tin material used when a tin oxide film is formed by CVD include monobutyltin trichloride, tin tetrachloride, dimethyltin dichloride, dibutyltin dichloride, dioctyltin dichloride, tetramethyltin and the like. For formation of the first undercoating film, an organic tin chloride such as monobutyltin trichloride and dimethyltin dichloride is preferred. As the oxidizing material, oxygen, water vapor, dry air and the like may be used. Examples of the fluorine material used when fluorine is added to the conductive film include hydrogen fluoride, trifluoroacetic acid, bromotrifluoromethane, chlorodifluoromethane and the like.

When a titanium oxide film, an indium oxide film or a zinc oxide film is formed, a chloride of the metal (titanium tetrachloride, zinc dichloride or the like), for example, may be used in place of the tin material described above.

Examples of the silicon material used when a thin film including silicon oxide as a main component is formed by CVD include monosilane, disilane, trisilane, monochlorosilane, 1,2-dimethylsilane, 1,1,2-trimethyldisilane, 1,1,2,2-tetramethyl disilane, tetramethyl orthosilicate, tetraethyl orthosilicate and the like. As the oxidizing material in this case, oxygen, water vapor, dry air, carbon dioxide, carbon monoxide, nitrogen dioxide, ozone and the like may be used. When a material having considerably high reactivity such as monosilane is used, an unsaturated hydrocarbon gas such as ethylene, acetylene and toluene may be added to control the reactivity.

Examples of the aluminum material used when an aluminum oxide film is formed by CVD include trimethylaluminum, aluminum triisopropoxide, diethylaluminum chloride, aluminum acetylacetonate and aluminum chloride. As the oxidizing material in this case, oxygen, water vapor, dry air and the like may be suitably used.

The CVD method described above is also applicable to formation of concavities using a corrosive gas. A process using a corrosive gas easily can be incorporated in the mass-production process by CVD in which the film forming material is supplied as a gas. The substrate of the present invention can be efficiently mass-produced by the continuous formation of films by CVD, although manufacture by other film forming methods is not excluded.

### Examples

Hereinafter, the present invention will be described in more detail by way of examples. It should be noted that the present invention is not limited to these examples.

In the following examples and comparative examples, thin films were formed on the surface of a glass ribbon by CVD using a plurality of coaters as described above. In the film forming process, a mixed gas of 98 vol.% of nitrogen and 2 vol.% of hydrogen was supplied into the space of the tin float bath, so that the pressure inside the bath was maintained a little higher than that outside the bath. Soda lime glass material melted in the melting furnace was poured into the tin float bath, to be formed into a glass ribbon having a thickness of 4 mm. The glass ribbon, on the top surface of which predetermined thin films were formed inside the bath, was cooled slowly in the annealing furnace, and then subjected to washing, drying and cutting at downstream stages. Hereinafter, specific film forming methods will be described.

### (Comparative Example 1)

The surface temperature of the glass ribbon immediately before arrival at the coater positioned furthest upstream was set at 750°C. A mixed gas of dimethyltin dichloride (DMT), oxygen, helium and nitrogen was supplied from this coater. A mixed gas of monosilane, ethylene, oxygen and nitrogen was then supplied from a coater positioned downstream. Subsequently, a mixed gas of DMT, oxygen, water vapor, nitrogen and hydrogen fluoride was supplied from a coater positioned further downstream. In this way, a sample was obtained in which a tin oxide film having a thickness of about 30 nm, a silicon oxide film having a thickness of about 30 nm and a fluorine-containing tin oxide film having a thickness of about 850 nm were formed in this order on the top surface of the glass ribbon.

### (Comparative Example 2)

A sample was obtained in the same manner as that in Comparative Example 1, except that the surface temperature of the glass ribbon immediately before arrival at the coater positioned furthest upstream was set at 700°C.

### (Comparative Example 3)

A sample was obtained in the same manner as that in Comparative Example 1, except that the surface temperature of the glass ribbon immediately before arrival at the coater positioned furthest upstream was set at 650°C.

### (Example 1)

A sample was obtained in the same manner as that in Comparative Example 1, except that hydrogen chloride was added to the gas supplied from the coater positioned furthest upstream. The added amount of hydrogen chloride was 10 mol% of the mixed gas (film forming gas).

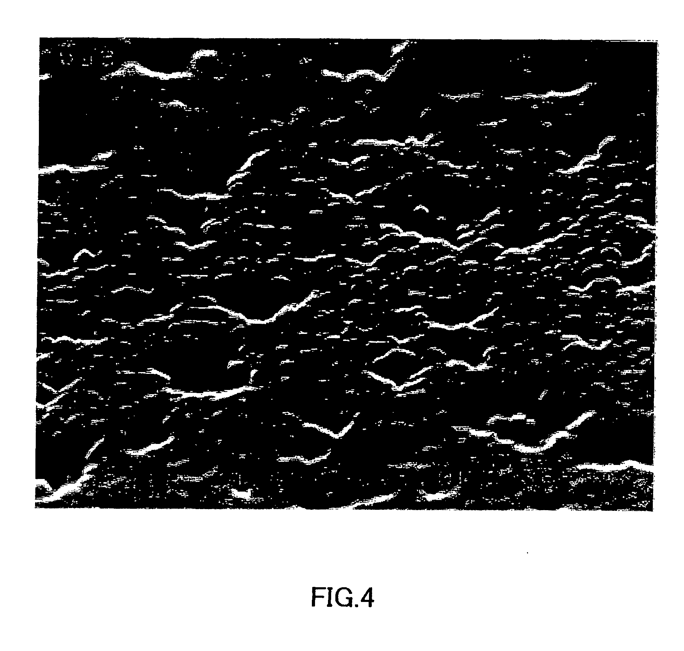

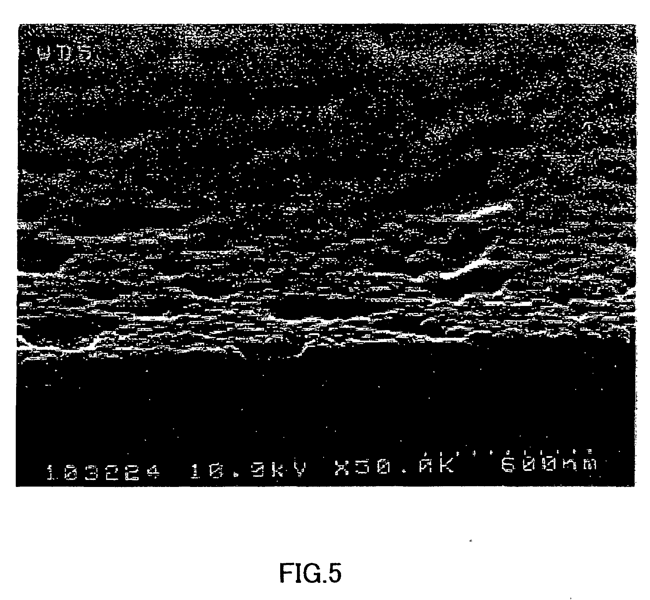

The samples obtained from Example 1 and Comparative Examples 1 to 3 were irradiated with light from the side of the glass sheet, and the haze ratio was measured for the respective samples according to a haze measuring method (JIS K7105-1981). Subsequently, only the fluorine-containing tin oxide film was removed from the surface of each sample by etching with hydrochloric acid using zinc powder as a catalyst, to expose the surface of the silicon oxide film. This surface was observed with a scanning electron microscope (SEM), to evaluate the mean diameter of concavities in the film surface and the area ratio of the concavities. This SEM evaluation was performed for 4 µm² of the film surface. The evaluation results are shown in Table 1, and the surface state, observed with the SEM, of the sample of Example 1 after the etching is shown in FIGS. 4 and 5.

**Table 1**

| | Mean diameter of concavities (nm) | Area ratio of concavities (%) | Haze ratio (%) |
|---|---|---|---|
| Comparative Example 1 | 100 | 10 | 17.2 |
| Comparative Example 2 | 200 | 6 | 15.4 |
| Comparative Example 3 | 100 | 4 | 11.2 |
| Example 1 | 300 | 30 | 24.1 |

The samples obtained from Example 1 and Comparative Examples 1 to 3 after the etching were observed with a transmission electron microscope. As a result, holes and recesses of the tin oxide film were noticed below the concavities of the silicon oxide film. Crystal grains of tin oxide tended to become extremely large in the portions above the concavities.

During the haze ratio measurement, the transmittance of diffused light in the wavelength range of 650 nm to 1100 nm was measured for the samples of Example 1 and Comparative Example 1. The results are shown in Table 2.

**Table 2**

| Diffuse transmittance | | | | | | | | |
|---|---|---|---|---|---|---|---|---|
| Wavelength (nm) | 1100 | 1000 | 900 | 850 | 800 | 750 | 700 | 650 |
| Comparative Example 1 | 0.74 | 1.28 | 2.20 | 3.29 | 4.24 | 5.65 | 7.42 | 10.01 |
| Example 1 | 1.39 | 2.25 | 3.66 | 5.41 | 7.03 | 8.92 | 11.38 | 14.57 |

In the wavelength of 850 nm, for example, the diffuse transmittance, which was 3.3% in Comparative Example 1, rose to 5.4% in Example 1. A diffuse transmittance as high as the above value (5% or more) in this wavelength range indicates that this sample has excellent characteristics as the substrate for a photoelectric conversion device having high sensitivity for the long wavelength range.

### (Example 2)

A substrate for a photoelectric conversion device, of which the first undercoating film was substantially flat and the second undercoating film had concavities in the surface, was manufactured. Soda lime glass having a thickness of 1.1 mm, manufactured by the float method, was cut into 100 mm X 100 mm pieces, and washed and dried. The resultant glass sheet was placed in a CVD film forming apparatus and heated to 500°C. A mixed gas of monobutyltin trichloride, oxygen and nitrogen was supplied to the top surface of the glass sheet, to form a tin oxide film having a thickness of about 30 nm as the first undercoating film. After cooling to normal temperature, the surface of the film was observed with a SEM. As a result, the surface was found substantially flat with only minute surface irregularities generated with crystal growth of tin oxide noticed.

Thereafter, the glass sheet was placed back in the film forming apparatus and heated again to 500°C. After the heating, a mixed gas of monosilane, oxygen and nitrogen was supplied, to form a silicon oxide film having a thickness of about 30 nm as the second undercoating film. Subsequently, HF gas was sprayed on the surface of the silicon oxide film, to form concavities on the surface of the film, and then a mixed gas of .. monobutyltin trichloride, oxygen, water vapor, nitrogen and trifluoroacetic acid was supplied, to obtain a fluorine-containing tin oxide film having a thickness of about 850 nm as the conductive film.

The thus-obtained sample exhibited a haze ratio of about 20% and a diffuse transmittance of 3.8% at the wavelength of 850 nm. The surface of the silicon oxide film of this sample exposed in the manner described above was observed with a SEM. As a result, the mean diameter of the concavities was about 200 nm, and the area ratio of the concavities was about 20%.

### (Comparative Example 4)

A sample was obtained in the same manner as that in Example 2, except that the process step of spraying HF gas was omitted and the formation of the conductive film was omitted. The surface of the resultant sample (surface of the silicon oxide film) was observed with a SEM. As a result, the surface of the film was flat with no concave observed.

As described above, according to the present invention, a substrate for a photoelectric conversion device with a further enhanced haze can be provided. In this substrate, concavities and convexes, contributing to the light trapping effect of the photoelectric conversion device, exist scattered on the surface of the conductive film only with the film formation without the necessity of performing any post-treatment.

## Claims

1. A substrate for a photoelectric conversion device, comprising a first undercoating film containing at least one selected from tin oxide, titanium oxide, indium oxide and zinc oxide as a main component, a second undercoating film and a conductive film formed in this order on a glass sheet containing an alkali component, wherein concavities are formed in the surface of the second undercoating film, and the area ratio of the concavities is in a range of 20% to 50%.

2. The substrate for a photoelectric conversion device according to claim 1, wherein the mean diameter of the concavities is in a range of 200 nm to 600 nm.

3. The substrate for a photoelectric conversion device according to claim 1, wherein the concavities are formed in the surface of the second undercoating film by reflecting the surface profile of the first undercoating film.

4. The substrate for a photoelectric conversion device according to claim 3, wherein the first undercoating film has holes.

5. The substrate for a photoelectric conversion device according to claim 1, wherein the second undercoating film exists over the entire interface between the first undercoating film and the conductive film.

6. The substrate for a photoelectric conversion device according to claim 1, wherein the second undercoating film includes at least one selected from silicon oxide and aluminum oxide as a main component.

7. The substrate for a photoelectric conversion device according to claim 1, wherein the ratio of the thickness of the second undercoating film to the thickness of the first undercoating film is in a range of 0.2 to 2.0.

8. The substrate for a photoelectric conversion device according to claim 1, wherein the glass sheet is float glass, and the first undercoating film, the second undercoating film and the conductive film are formed on the top surface of the float glass.

9. A method of manufacturing a substrate for a photoelectric conversion device, comprising forming a first undercoating film containing at least one selected from tin oxide, titanium oxide, indium oxide and zinc oxide as a main component, a second undercoating film and a conductive film in this order on a glass sheet containing an alkali component or a glass ribbon in a glass sheet manufacturing process,
wherein the first undercoating film is formed on the glass sheet or the glass ribbon having a temperature of 600°C or more by chemical vapor deposition using a film forming gas so that concavities are formed on the surface of the first undercoating film, the film forming gas including a compound gas containing at least one of metal selected from tin, titanium, indium and zinc and a halogen-containing gas that does not contain the metal.

10. The method of manufacturing a substrate for a photoelectric conversion device according to claim 9, wherein the second undercoating film is formed so that concavities reflecting the concavities of the first undercoating film are formed in the surface of the second undercoating film.

11. The method of manufacturing a substrate for a photoelectric conversion device according to claim 9, wherein the compound gas contains a halogen.
